# EUROPEAN PATENT APPLICATION

(11) **EP 4 576 519 A1**
(43) Date of publication of application: **25.06.2025**
(21) Application number: 23891479.0
(22) Date of filing: 10.11.2023
(51) Int. Cl.: H02K 9/19, B60H 1/22, B60K 1/00, B60K 1/04, B60K 11/02, B60K 11/04, B60L 1/00, B60L 15/00, F01P 3/20, F01P 3/22, F01P 7/14, F01P 11/04, F01P 11/08, F25B 1/00, H02K 11/33, H05K 7/20

(54) **COOLING SYSTEM**

(30) Priority: 16.11.2022 JP 2022183674; 16.11.2022 JP 2022183675; 31.05.2023 JP 2023089637
(71) Applicant: AISIN CORPORATION, Kariya-shi, Aichi 448-8650 (JP)
(72) Inventor: KATSUDA, Takuya, Kariya-shi, Aichi 448-8650 (JP); MURAKAMI, Satoshi, Kariya-shi, Aichi 448-8650 (JP); MAEDA, Takuyo, Kariya-shi, Aichi 448-8650 (JP); KOSHIDA, Takafumi, Kariya-shi, Aichi 448-8650 (JP); KUROKAWA, Akifumi, Kariya-shi, Aichi 448-8650 (JP); KAWAMURA, Kazuya, Kariya-shi, Aichi 448-8650 (JP); SAIKI, Mika, Kariya-shi, Aichi 448-8650 (JP)
(74) Representative: Kramer Barske Schmidtchen Patentanwälte PartG mbB
(86) International application number: PCT/JP2023/040548
(87) International publication number: WO 2024/106330

(57) **Abstract**

A cooling system (A) includes: an integrated unit (1) in which an electric vehicle drive unit (2) including at least an electric motor (21) configured to transmit a drive rotational force to a traveling system of a vehicle and an electronic circuit unit (3) including at least an electronic circuit (31) configured to drive the electric motor (21) are integrated; a cooling channel (B) through which a coolant circulates to the electronic circuit unit (3); and an oil channel (C) that includes a heat exchanger (62) configured to exchange heat with the coolant circulating through the cooling channel (B) and through which oil circulates to the electric vehicle drive unit (2). The heat exchanger (62) is disposed inside the integrated unit (1) between the electric vehicle drive unit (2) and the electronic circuit unit (3).

## Description

### TECHNICAL FIELD

The present invention relates to a cooling system.

### BACKGROUND ART

Hitherto, there has been known an electric vehicle drive unit including at least an electric motor that transmits a drive rotational force to a traveling system of a vehicle (see, for example, Patent Document 1). This electric vehicle drive unit is downsized by integrally housing the electric motor and a gear unit into a housing, and is connected to a cooling system that exchanges heat between a coolant and oil circulating through the electric vehicle drive unit.

The cooling system described in Patent Document 1 includes an inverter unit attached to the electric vehicle drive unit, and exchanges heat between the coolant circulating from the inverter unit to an oil cooler and the oil circulating through the electric vehicle drive unit. The oil cooler is attached to a lower part of a motor housing portion of the electric vehicle drive unit, and a cooling pipe is routed between the oil cooler and the inverter unit.

### Related Art Documents

### Patent Documents

Patent Document 1: Japanese Unexamined Patent Application Publication No. 2020-178485 (JP 2020-178485 A)

### SUMMARY OF THE INVENTION

### Problem to be Solved by the Invention

In the cooling system described in Patent Document 1, the oil cooler is attached to the lower part of the housing, and the cooling pipe is exposed. Therefore, heat is dissipated through the cooling pipe, and the heat recovery rate decreases.

Therefore, there is a demand for a cooling system that is downsized and can perform efficient heat management.

### Means for Solving the Problem

A characteristic configuration of a cooling system according to the present invention is as follows. The cooling system includes: an integrated unit in which an electric vehicle drive unit including at least an electric motor configured to transmit a drive rotational force to a traveling system of a vehicle and an electronic circuit unit including at least an electronic circuit configured to drive the electric motor are integrated; a cooling channel through which a coolant circulates to the electronic circuit unit; and an oil channel that includes a heat exchanger configured to exchange heat with the coolant circulating through the cooling channel and through which oil circulates to the electric vehicle drive unit. The heat exchanger is disposed inside the integrated unit between the electric vehicle drive unit and the electronic circuit unit.

In this configuration, the integrated unit in which the electric vehicle drive unit and the electronic circuit unit are integrated is provided. Therefore, downsizing can be achieved compared with a case where the electric vehicle drive unit and the electronic circuit unit are disposed separately. With the heat exchanger that exchanges heat between the coolant and the oil, the waste heat of the electric vehicle drive unit can be recovered by the coolant.

In this configuration, the heat exchanger is disposed inside the integrated unit between the electric vehicle drive unit and the electronic circuit unit. Thus, heat can be exchanged between the oil and the coolant inside the integrated unit, thereby improving the heat recovery rate. In the cooling channel, the length of the pipe exposed from the heat exchanger to the outside can be reduced.

In this way, the cooling system can suppress the dissipation of the waste heat of the electric vehicle drive unit from the cooling pipe, thereby achieving downsizing and efficient heat management.

### BRIEF DESCRIPTION OF THE DRAWINGS

[FIG. 1] FIG. 1 is a perspective view of an integrated unit.
[FIG. 2] FIG. 2 is a partial sectional view of the integrated unit.
[FIG. 3] FIG. 3 is a schematic diagram showing a cooling system of a first embodiment.
[FIG. 4] FIG. 4 is a diagram showing a circuit configuration of the cooling system of the first embodiment.
[FIG. 5] FIG. 5 is a schematic diagram showing a flow of a coolant in the cooling system of the first embodiment.
[FIG. 6] FIG. 6 is a diagram showing the configuration of upper and lower surfaces of an oil cooler.
[FIG. 7] FIG. 7 is a schematic diagram showing a cooling system of a second embodiment.
[FIG. 8] FIG. 8 is a schematic diagram showing a cooling system of a third embodiment.
[FIG. 9] FIG. 9 is a schematic diagram showing a cooling system of a fourth embodiment.
[FIG. 10] FIG. 10 is a schematic diagram showing the cooling system of the fourth embodiment.

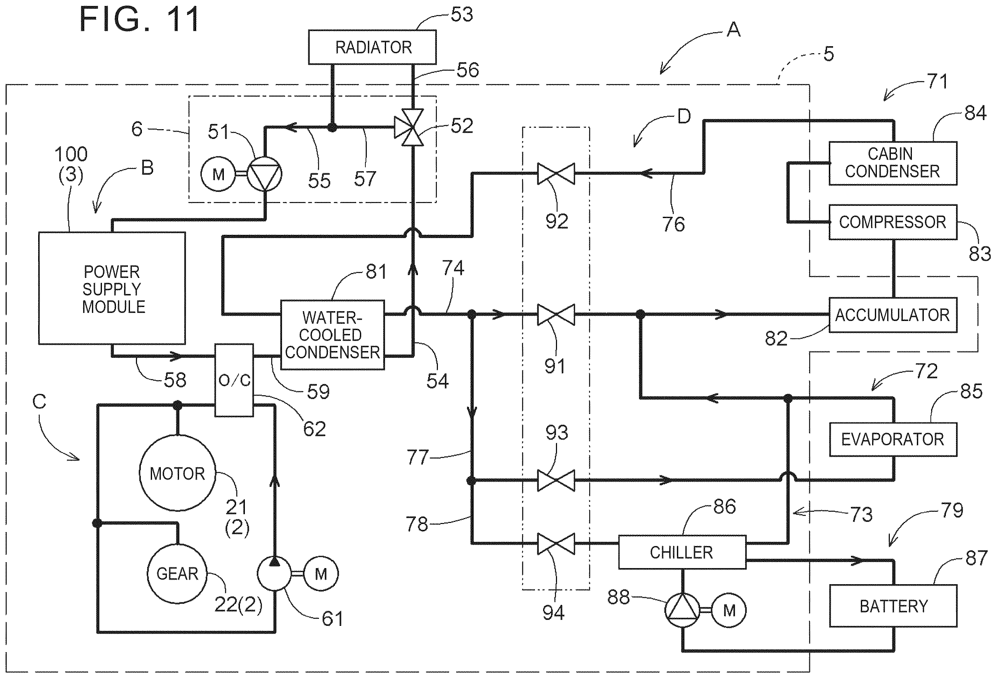

[FIG. 11] FIG. 11 is a diagram showing a circuit configuration of the cooling system of the fourth embodiment.
[FIG. 12] FIG. 12 is a side view of a water-cooled plate housed in the integrated unit.
[FIG. 13] FIG. 13 is a perspective view of the water-cooled plate to which the oil cooler is attached.
[FIG. 14] FIG. 14 is a partial perspective sectional view of the integrated unit of the fourth embodiment.
[FIG. 15] FIG. 15 is a partial side view of the integrated unit of the fourth embodiment.
[FIG. 16] FIG. 16 is a partial side view of the integrated unit of the fourth embodiment.
[FIG. 17] FIG. 17 is a schematic diagram showing a cooling system of a fifth embodiment.

### MODES FOR CARRYING OUT THE INVENTION

Hereinafter, embodiments of a cooling system according to the present invention will be described with reference to the drawings. However, the present invention is not limited to the following embodiments, and various modifications may be made without departing from the spirit of the present invention.

An electric vehicle includes an electric vehicle drive unit that drives wheels with a current supplied from a battery. Examples of the electric vehicle include vehicles including a motor as a traveling drive source (hybrid electric vehicle (HEV), plug-in hybrid electric vehicle (PHEV), battery electric vehicle (BEV), fuel cell electric vehicle (FCEV), etc.).

### [First Embodiment]

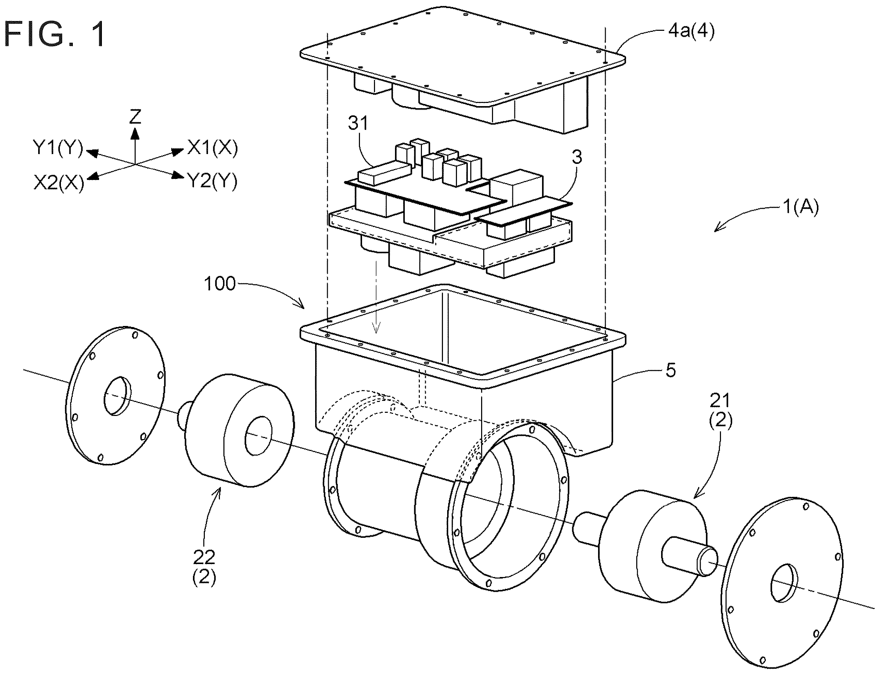

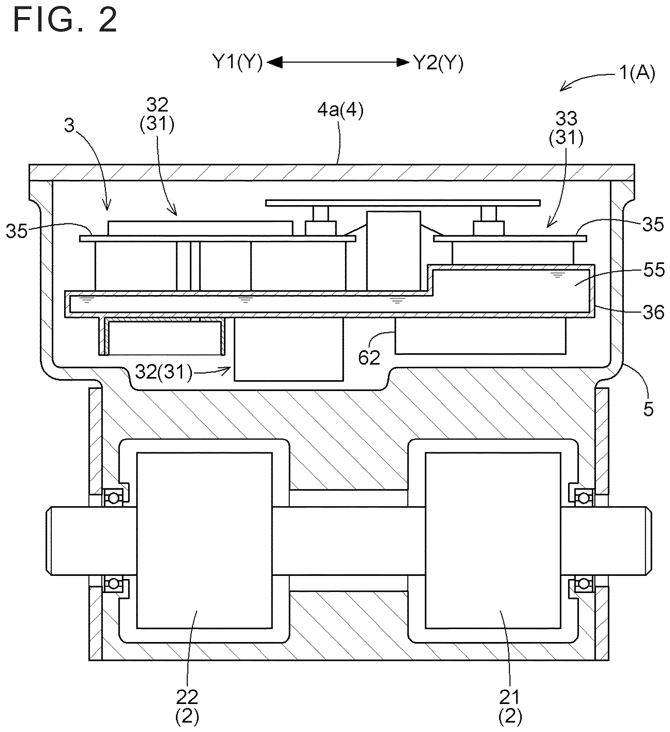

The electric vehicle includes an integrated unit 1 shown in FIGS. 1 and 2. The integrated unit 1 includes an electric vehicle drive unit 2 (hereinafter referred to as "vehicle drive unit 2"), an electronic circuit unit 3, and a cooling module 4. In the integrated unit 1, the vehicle drive unit 2 and the electronic circuit unit 3 are integrally housed in a unit case 5 (an example of a housing). The cooling module 4 is disposed to adjoin the electronic circuit unit 3. In the example shown in FIG. 1, a chiller 86, a water-cooled condenser 81, an accumulator 82, and auxiliary devices such as valves and pumps described later and portions of a cooling channel B and a refrigerant channel D are modularized as the cooling module 4 and housed in the unit case 5. A cooling system A in the present embodiment described below is an example in which only the vehicle drive unit 2 and the electronic circuit unit 3 are housed in the unit case 5, but the shape and structure of the integrated unit 1 are not particularly limited. In the following figures, as shown in, for example, FIG. 1, the traveling direction of the vehicle (vehicle front-to-rear direction) may be referred to as an X direction, the width direction of the vehicle (vehicle left-to-right direction) may be referred to as a Y direction, and the height direction of the vehicle may be referred to as a Z direction. The front side in the traveling direction of the vehicle may be referred to as an X1 side, the rear side in the traveling direction may be referred to as an X2 side, the left side in the vehicle width direction may be referred to as a Y1 side, and the right side in the vehicle width direction may be referred to as a Y2 side.

The vehicle drive unit 2 includes at least an electric motor 21 that transmits a drive rotational force to a traveling system of the vehicle. Specifically, the vehicle drive unit 2 includes the electric motor 21, gears 22 including a speed reducing mechanism, etc. The electronic circuit unit 3 includes at least electronic circuits 31 for driving the electric motor 21. Specifically, the electronic circuit unit 3 is housed in the unit case 5 to form a power supply module 100, and a plurality of electronic components constituting on-board chargers (OBCs) 32 (an example of a voltage conversion circuit) and an inverter (INV) 33 as the electronic circuits 31 is mounted on a substrate 35. The electronic components mounted on the substrate 35 are cooled by a cooling plate 36 including part of a second channel 55 of the cooling channel B described later. Thus, the electronic circuit unit 3 (power supply module 100) is coolable by a coolant flowing through the cooling channel B.

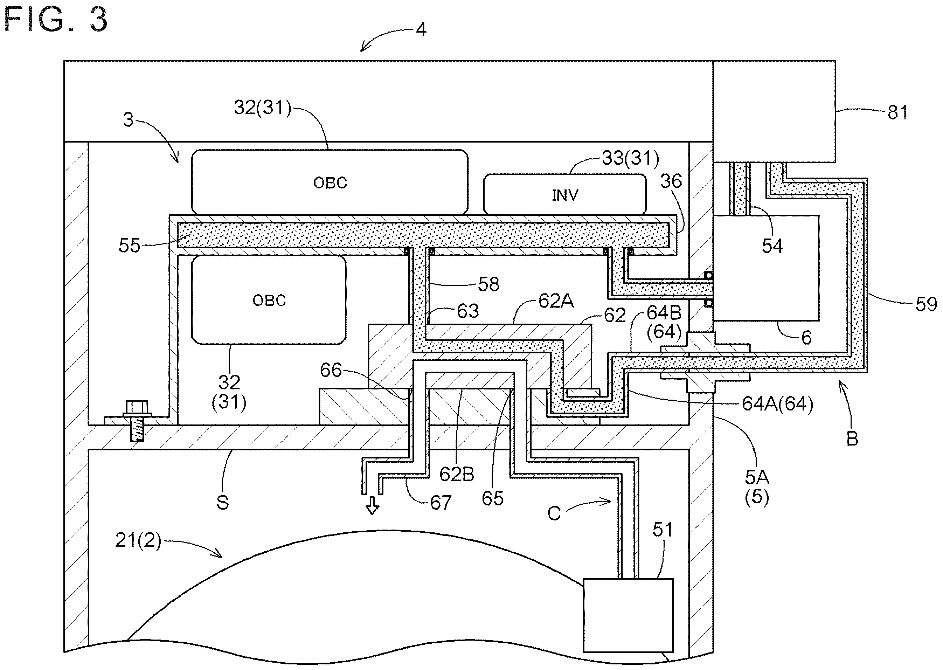

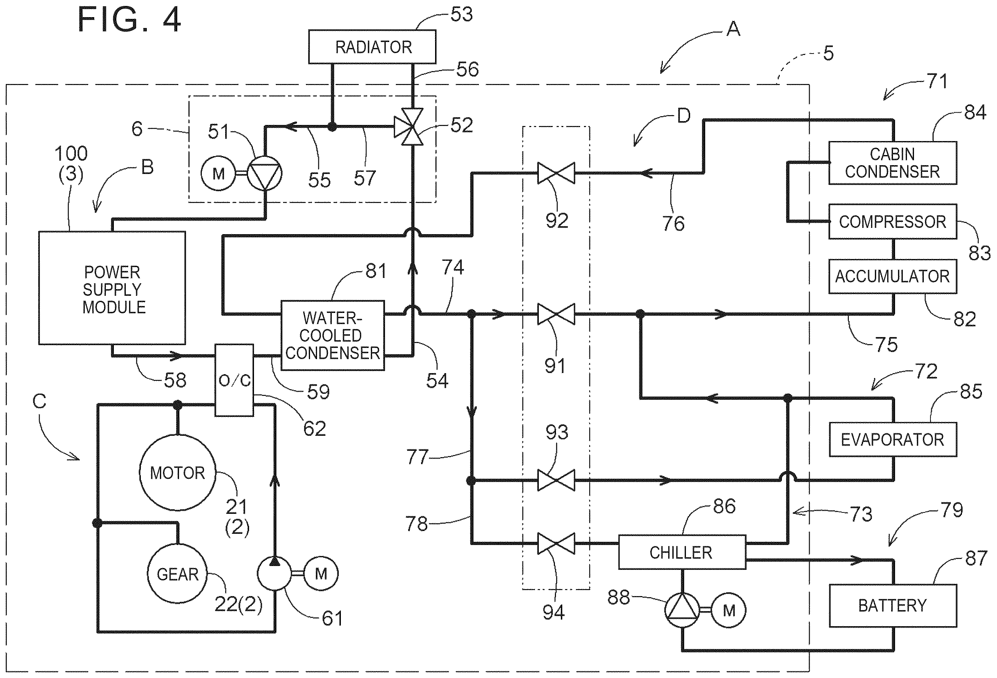

As shown in FIGS. 3 and 4, the cooling system A includes the integrated unit 1 in which the vehicle drive unit 2 and the electronic circuit unit 3 are integrated, the cooling channel B through which the coolant circulates to the electronic circuit unit 3 (power supply module 100), an oil channel C through which oil circulates to the vehicle drive unit 2, and the refrigerant channel D through which a refrigerant for heating and cooling a vehicle cabin circulates. A coolant such as an antifreeze liquid mainly containing ethylene glycol etc. or a long-life coolant or a coolant such as insulating oil flows through the cooling channel B. A refrigerant such as hydrofluorocarbon (HFC) flows through the refrigerant channel D.

The electronic circuit unit 3 is disposed on an upper part of the unit case 5 and fixed to a support S. The vehicle drive unit 2 is disposed below the support S. The disposition of the vehicle drive unit 2 and the electronic circuit unit 3 is not limited to this. The vehicle drive unit 2 and the electronic circuit unit 3 may be arranged along the X direction or the Y direction. The vehicle drive unit 2 may be disposed on the upper side and the electronic circuit unit 3 may be disposed on the lower side. The cooling module 4 is disposed to adjoin the electronic circuit unit 3. Specifically, a refrigerant manifold 4a is disposed on the upper part of the unit case 5, and the water-cooled condenser 81 is disposed on the side of the refrigerant manifold 4a. A valve unit 6 in which a water pump 51 and a valve 52 (see FIG. 4) disposed in the cooling channel B are integrated is disposed on a side surface 5A of the unit case 5 below the water-cooled condenser 81.

The cooling channel B will be described. The cooling channel B is a channel shown above the electric motor 21 in FIGS. 3 and 4. The cooling channel B includes the valve unit 6, the power supply module 100, an oil cooler 62 (an example of a heat exchanger) described later, the water-cooled condenser 81, a radiator 53, etc. provided midway along the channel. The cooling channel B includes a first channel 54 extending from the water-cooled condenser 81 to the radiator 53, and the second channel 55 extending from the radiator 53 to the water-cooled condenser 81. The electronic circuit unit 3 has part of the second channel 55 of the cooling channel B as an internal channel of the cooling plate 36. Part of the cooling channel B is disposed inside the unit case 5.

In the cooling channel B, the coolant circulates through the power supply module 100 (electronic circuit unit 3), the oil cooler 62, the water-cooled condenser 81, and the radiator 53 in this order. In the cooling channel B, the valve 52 (an example of a three-way valve) switchable between a first state in which the coolant flows through the radiator 53 and a second state in which the flow of the coolant into the radiator 53 is blocked and the coolant is diverted is disposed in the first channel 54 through which the coolant is supplied to the radiator 53. Thus, the cooling channel B can be switched by the valve 52 between a channel 56 in which the coolant passes through the radiator 53 and joins the second channel 55 and a channel 57 in which the coolant flows without passing through the radiator 53 and joins the second channel 55. In the cooling channel B, the water pump 51 is disposed downstream of the valve 52 and the radiator 53. The cooling channel B also includes a channel 58 extending from the electronic circuit unit 3 to the oil cooler 62, and a channel 59 extending from the oil cooler 62 to the water-cooled condenser 81.

Next, the oil channel C will be described. The oil channel C is a channel shown below the electronic circuit unit 3 in FIGS. 3 and 4. The oil channel C includes an oil pump 61 and the oil cooler 62 (an example of the heat exchanger) provided midway along the channel. Oil is supplied to the electric motor 21 etc. and circulates through the vehicle drive unit 2. The oil cooler 62 is located downstream of the power supply module 100 (electronic circuit unit 3) in the cooling channel B, and exchanges heat with the coolant circulating through the cooling channel B.

Next, the refrigerant channel D will be described. The refrigerant channel D is a channel shown on the right side in FIG. 4, and the refrigerant for heating and cooling circulates therethrough. The refrigerant channel D includes a heating channel 71 through which a refrigerant for heating the vehicle cabin circulates, a cooling channel 72 through which a refrigerant for cooling the vehicle cabin circulates, and a battery cooling channel 73 through which the refrigerant circulates to cool a battery 87 mounted on the vehicle. The heating channel 71 includes the water-cooled condenser 81, the accumulator 82, a compressor 83, and a cabin condenser 84 (heating condenser) disposed in this order to constitute a heat pump as a whole. The refrigerant channel D includes the water-cooled condenser 81 provided midway along the channel to exchange heat with the coolant circulating through the cooling channel B. The water-cooled condenser 81 is located downstream of the oil cooler 62 in the cooling channel B, and exchanges heat with the coolant circulating through the cooling channel B.

In the heating channel 71, an on-off valve 91 is disposed in a channel 74 between the water-cooled condenser 81 and the accumulator 82, and a first expansion valve 92 is disposed in a channel 76 between the cabin condenser 84 and the water-cooled condenser 81. In the example shown in FIG. 4, the compressor 83, the cabin condenser 84, and a channel 75 passing through them are disposed outside the unit case 5.

The cooling channel 72 is constituted by a channel 77 that branches from the channel 74 on the upstream side of the on-off valve 91. The channel 77 includes a second expansion valve 93 and an evaporator 85 provided in this order midway along the channel, and joins the channel 74 on the downstream side of the on-off valve 91. That is, when the second expansion valve 93 is driven with the on-off valve 91 closed, the refrigerant flows through the channel 77 and the evaporator 85 cools the vehicle cabin. In the example shown in FIG. 1, the evaporator 85 in the cooling channel 72 is disposed outside the unit case 5.

The battery cooling channel 73 is constituted by a channel 78 that branches from the channel 77 of the cooling channel 72 on the upstream side of the second expansion valve 93. The channel 78 includes a third expansion valve 94 and the chiller 86 provided in this order midway along the channel, and joins the channel 77 on the downstream side of the evaporator 85. That is, when the third expansion valve 94 is driven with the on-off valve 91 closed, the refrigerant flows through the channel 78, and the chiller 86 exchanges heat between the refrigerant and a coolant circulating through a cooling circuit 79. In the refrigerant channel D, it is preferable that the on-off valve 91, the first expansion valve 92, the second expansion valve 93, and the third expansion valve 94 be modularized and integrated with the cooling module 4, and be housed inside the cooling module 4.

The battery cooling channel 73 is structured such that the chiller 86 is disposed in the cooling circuit 79 through which the coolant circulates between the chiller 86 and the battery 87. A water pump 88 is disposed in the cooling circuit 79 midway along the channel. In the example shown in FIG. 1, the battery 87 in the battery cooling channel 73 is disposed, for example, in a space under the floor of the vehicle cabin that is located outside and rearward of the unit case 5.

In the present embodiment, the integrated unit 1 in which the vehicle drive unit 2 and the electronic circuit unit 3 (power supply module 100) are integrated is provided. Therefore, downsizing can be achieved compared with a case where the vehicle drive unit 2 and the electronic circuit unit 3 (power supply module 100) are disposed separately. With the oil cooler 62 that exchanges heat between the coolant and the oil, waste heat of the vehicle drive unit 2 can be recovered by the coolant.

As shown in FIGS. 2 and 3, the oil cooler 62 is disposed inside the integrated unit 1 between the vehicle drive unit 2 and the electronic circuit unit 3 (power supply module 100). The oil cooler 62 is disposed, for example, below the electronic circuit unit 3 and is provided downstream of the second channel 55 formed inside the cooling plate 36. Thus, heat can be exchanged between the oil circulating through the oil channel C and the coolant circulating through the cooling channel B inside the integrated unit 1, thereby improving the heat recovery rate. In the cooling channel B, the length of the pipe exposed from the oil cooler 62 to the outside can be reduced.

In this way, the cooling system A of the present embodiment can suppress dissipation of the waste heat of the vehicle drive unit 2 from the cooling pipe, thereby achieving downsizing and efficient heat management.

The electronic circuits 31 of the electronic circuit unit 3 include the inverter (INV) 33 that controls the current to be supplied from the battery 87 to the electric motor 21, and the on-board chargers (OBCs) 32 that control the voltage for charging the battery 87. In the present embodiment, as shown in FIG. 3, the inverter 33 is disposed on the upper part of the electronic circuit unit 3, and the on-board chargers 32 are disposed on the upper and lower parts of the electronic circuit unit 3. When the electronic circuits 31 included in the electronic circuit unit 3 include not only the inverter 33 but also the on-board chargers 32 in this way, the cooling system A can further be downsized. The disposition of the electronic circuits 31 mounted on the electronic circuit unit 3 shown in FIG. 3 is an example, and the disposition of the electronic circuits 31 may be changed as appropriate.

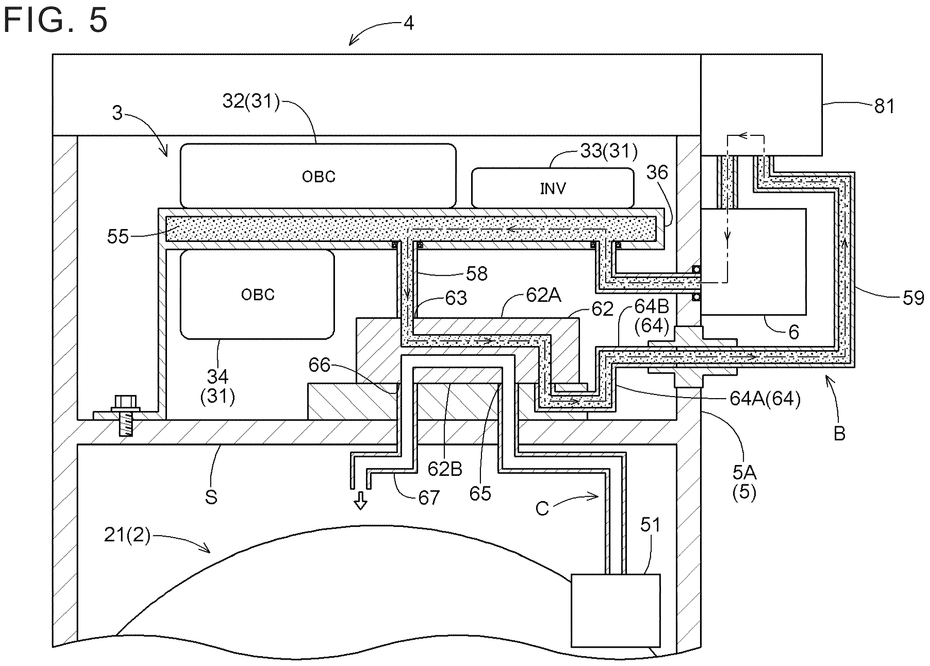

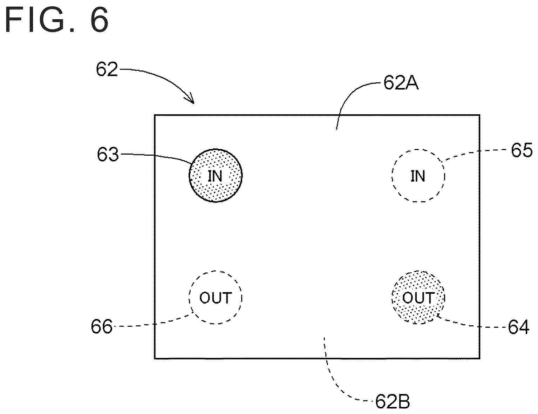

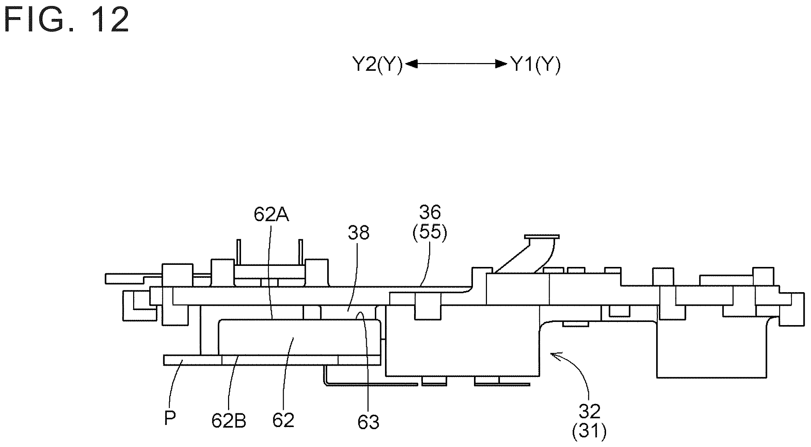

As shown in FIGS. 5, 6, and 12, the oil cooler 62 is formed in a box shape with, for example, an upper surface 62A near the electronic circuits 31 and a lower surface 62B near the electric motor 21. In the oil cooler 62, a coolant inlet 63 through which the coolant flows in from the top is provided on the upper surface 62A, and a coolant outlet 64 that extends toward the side of the oil cooler 62 and through which the coolant flows out is provided on the lower surface 62B. The coolant outlet 64 includes a first portion 64A that is bent from the lower surface 62B toward the upper surface 62A, and a second portion 64B that is continuous with the first portion 64A and extends along the upper surface 62A. The coolant can flow out from the side of the oil cooler 62 to the outside of the electronic circuit unit 3 (power supply module 100). The channel 59 that is continuous with the water-cooled condenser 81 from the coolant outlet 64 of the oil cooler 62 is formed through the side surface 5A of the unit case 5 and is disposed along the outer side of the valve unit 6.

With this configuration, the coolant pipe connected to the oil cooler 62 does not occupy a large area in the height direction of the oil cooler 62, and the integrated unit 1 can be made compact even when the oil cooler 62 is disposed between the vehicle drive unit 2 and the electronic circuit unit 3 (power supply module 100).

Further, the oil cooler 62 includes, individually on the lower surface 62B, an oil inlet 65 through which the oil flows in, and an oil outlet 66 through which the oil flows out. Thus, the integrated unit 1 can be made compact even when the oil cooler 62 is disposed between the vehicle drive unit 2 and the electronic circuit unit 3 (power supply module 100).

The oil outlet 66 of the oil cooler 62 is connected to a supply portion 67 that supplies the oil toward the electric motor 21. The oil flowing out from the supply portion 67 flows out from the lower surface 62B of the oil cooler 62 toward the electric motor 21. In this way, the oil can flow out from the lower surface 62B of the oil cooler 62 toward the electric motor 21.

### [Second Embodiment]

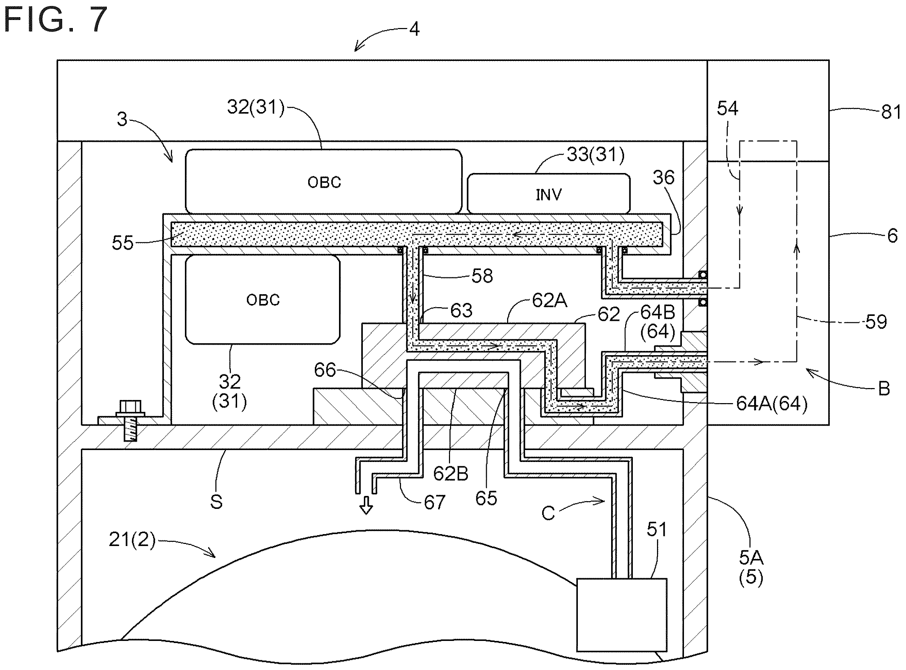

The first embodiment illustrates the example in which the channel between the oil cooler 62 and the water-cooled condenser 81 is exposed to the outside. Alternatively, as shown in FIG. 7, the valve unit 6 (cooling manifold) in which part of the cooling channel B is formed inside the housing may be attached integrally to the integrated unit 1. Specifically, in the example shown in FIG. 7, the water-cooled condenser 81 and the valve unit 6 are integrated, and the channel 59 extending from the oil cooler 62 to the water-cooled condenser 81 and part of the first channel 54 extending from the water-cooled condenser 81 to the valve 52 and the water pump 51 are provided inside the valve unit 6 to form a manifold.

In the present embodiment, the integrated unit 1 in which the vehicle drive unit 2 and the electronic circuit unit 3 (power supply module 100) are integrated is provided. Therefore, downsizing can be achieved compared with a case where the vehicle drive unit 2 and the electronic circuit unit 3 (power supply module 100) are disposed separately. Further, the oil cooler 62 that exchanges heat between the coolant and the oil and the water-cooled condenser 81 that exchanges heat between the coolant and the refrigerant are provided. That is, the temperature of the coolant changes in the oil cooler 62 by utilizing the waste heat of the vehicle drive unit 2 and in the water-cooled condenser 81 by utilizing the heat of the refrigerant.

In the present embodiment, the valve unit 6 in which part of the cooling channel B is formed inside the housing is attached integrally to the integrated unit 1. That is, part of the cooling channel B through which the coolant circulates to exchange heat with both the oil and the refrigerant is integrated with the integrated unit 1. Thus, the length of the cooling pipe routed in the cooling channel B can be reduced, and the dissipation of the waste heat of the vehicle drive unit 2 from the cooling pipe can be suppressed.

In this way, the cooling system A of the present embodiment can also achieve downsizing and efficient heat management.

The valve unit 6 in which part of the cooling channel B is formed inside the housing is disposed on the side surface of the electronic circuit unit 3 (power supply module 100). By disposing the valve unit 6 on the side surface of the electronic circuit unit 3, the cooling pipe of the cooling channel B extending from the oil cooler 62 disposed near the vehicle drive unit 2 adjacent to the electronic circuit unit 3 can be designed so as not to be exposed to the outside. As a result, the dissipation of the waste heat of the vehicle drive unit 2 from the cooling pipe of the cooling channel B can be suppressed.

In the present embodiment, the water-cooled condenser 81 is attached integrally to the valve unit 6, and the cooling channel B that communicates with the water-cooled condenser 81 is formed inside the valve unit 6. Thus, the cooling pipe of the cooling channel B can be designed so as not to be exposed to the outside when heat is exchanged between the coolant circulating through the cooling channel B and the refrigerant circulating through the refrigerant channel D. As a result, the dissipation of the waste heat of the vehicle drive unit 2 from the cooling pipe of the cooling channel B can be suppressed.

### [Third Embodiment]

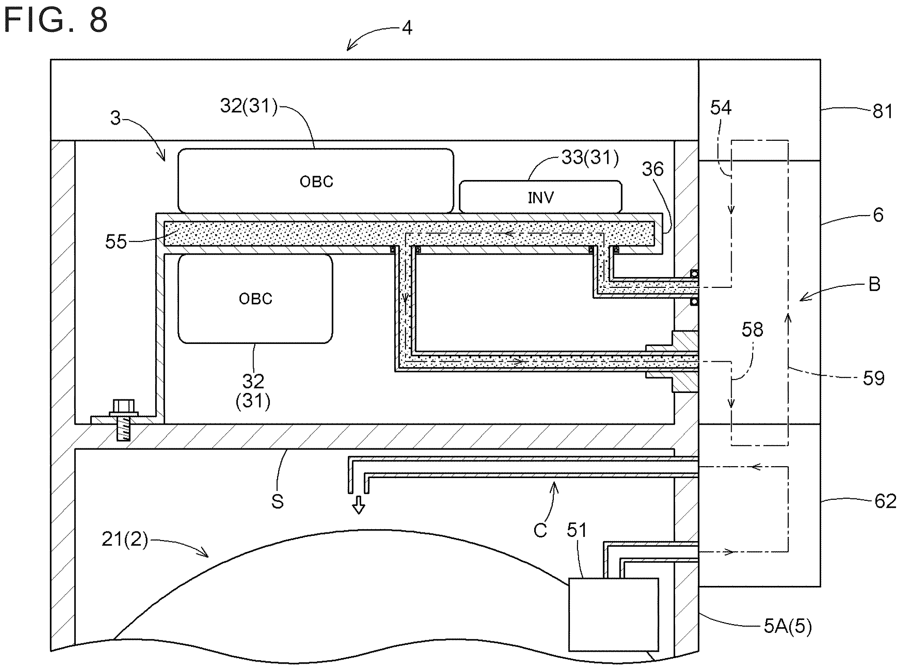

In a third embodiment, as shown in FIG. 8, the oil cooler 62 is disposed on the side surface 5A of the unit case 5, and the water-cooled condenser 81, the valve unit 6, and the oil cooler 62 are attached integrally to the integrated unit 1. The channels of the cooling channel B that communicate with the water-cooled condenser 81 and the oil cooler 62 are formed Inside the valve unit 6. Specifically, the channel 58 extending from the electronic circuit unit 3 (power supply module 100) to the oil cooler 62, the channel 59 extending from the oil cooler 62 to the water-cooled condenser 81, and part of the first channel 54 extending from the water-cooled condenser 81 to the valve 52 and the water pump 51 are provided inside the valve unit 6 to form a manifold.

By integrally attaching, to the valve unit 6, the oil cooler 62 disposed in the oil channel C through which the oil is supplied to the vehicle drive unit 2 as in the present embodiment, the cooling pipe of the cooling channel B can be designed so as not to be exposed to the outside when heat is exchanged between the coolant and the oil. As a result, the dissipation of the waste heat of the vehicle drive unit 2 from the cooling pipe of the cooling channel B can be suppressed.

### [Fourth Embodiment]

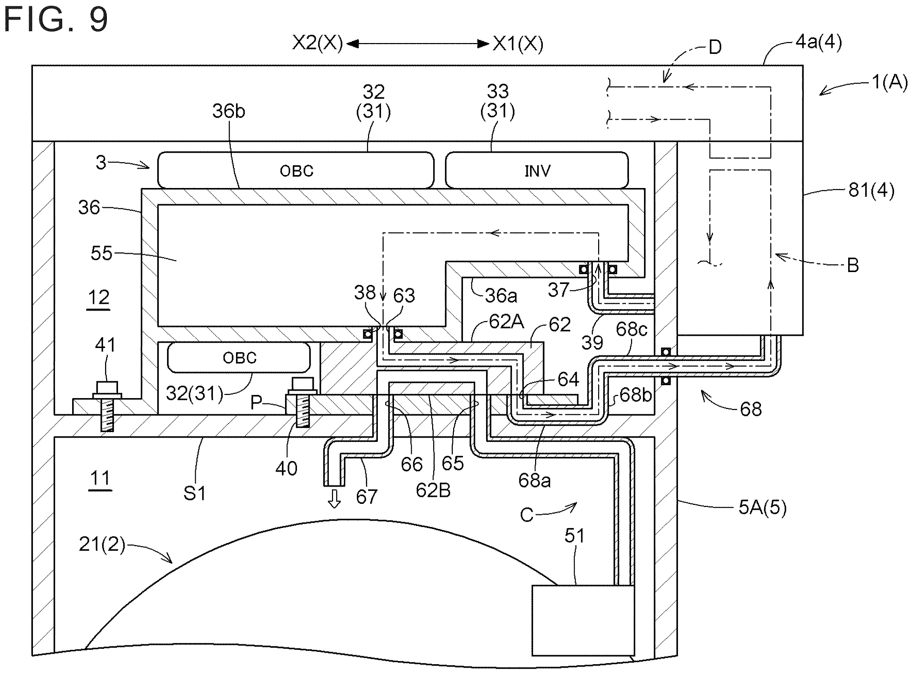

In a fourth embodiment, as shown in FIG. 9, the integrated unit 1 has a first space 11 in which the vehicle drive unit 2 is disposed, a second space 12 in which the electronic circuit unit 3 is disposed, and a partition wall S1 that separates the first space 11 and the second space 12. That is, the integrated unit 1 is partitioned into the first space 11 at the bottom and the second space 12 at the top by the partition wall S1.

The electronic circuit unit 3 is disposed on the upper part of the unit case 5 and fixed to the partition wall S1. The vehicle drive unit 2 is disposed below the partition wall S1. As shown in FIG. 9, the cooling module 4 is disposed to adjoin the electronic circuit unit 3. Specifically, the refrigerant manifold 4a is disposed on the upper part of the unit case 5, and the water-cooled condenser 81 is attached to the side surface 5A (an example of an outer surface) of the unit case 5. In this way, the integrated unit 1 includes the cooling module 4 in which the refrigerant manifold 4a including the refrigerant channel D through which the refrigerant flows and the water-cooled condenser 81 are integrated. In the cooling module 4, the refrigerant manifold 4a is located above the water-cooled condenser 81.

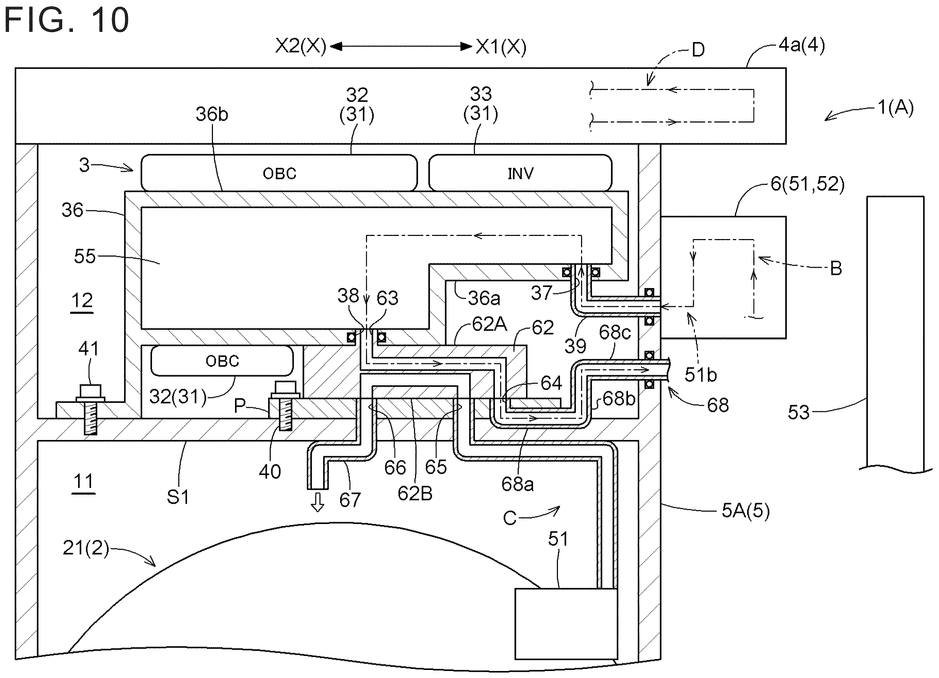

As shown in FIG. 10, the valve unit 6 is disposed on the side surface 5A of the unit case 5. In the present embodiment, on the side surface 5A of the unit case 5, the water-cooled condenser 81 is located on the left side (Y1 direction side) of the front side (X1 direction side), and the valve unit 6 is located on the right side (Y2 direction side) of the front side (X1 direction side).

As shown in FIGS. 9 and 10, the second space 12 of the unit case 5 houses the electronic circuit unit 3 and the cooling plate 36 for cooling the power supply module 100. The cooling plate 36 is made of a metal having high thermal conductivity, such as aluminum, and is integrally formed by joining a lower plate 36a and an upper plate 36b each having a plate shape by a method such as welding. The cooling plate 36 has a space inside (between the lower plate 36a and the upper plate 36b), and the coolant flows through the space. By exchanging heat between the power supply module 100 and the coolant, the temperature of the power supply module 100 is reduced and the temperature of the coolant is increased.

As shown in FIGS. 9 and 10, the second channel 55 of the cooling plate 36 is disposed in a horizontal direction. In the present embodiment, the coolant flows in through an inlet 37 of the cooling plate 36 and flows out through an outlet 38.

The oil cooler 62 is engaged with the cooling plate 36 via a projection and a recess while being disposed in the second space 12. Specifically, the outlet 38 formed in the lower plate 36a of the cooling plate 36 is a tubular portion that protrudes downward, and the outlet 38 of the cooling plate 36 is inserted and fitted into the coolant inlet 63 of the oil cooler 62. Although illustration is omitted, the coolant inlet 63 of the oil cooler 62 may be formed as a tubular portion that protrudes upward, and the outlet 38 of the cooling plate 36 may be formed as an opening. In this case, the coolant inlet 63 (tubular portion) of the oil cooler 62 is inserted and fitted into the outlet 38 of the cooling plate 36. A support plate P is joined to the lower surface 62B of the oil cooler 62, and the oil cooler 62 is positioned relative to the partition wall S1 and fastened to the partition wall S1 with screw members 40 etc. (see FIG. 10 as well). Similarly, the electronic circuit unit 3 including the cooling plate 36 is positioned relative to the partition wall S1 and fastened to the partition wall S1 with screw members 41 etc. (see FIG. 10 as well).

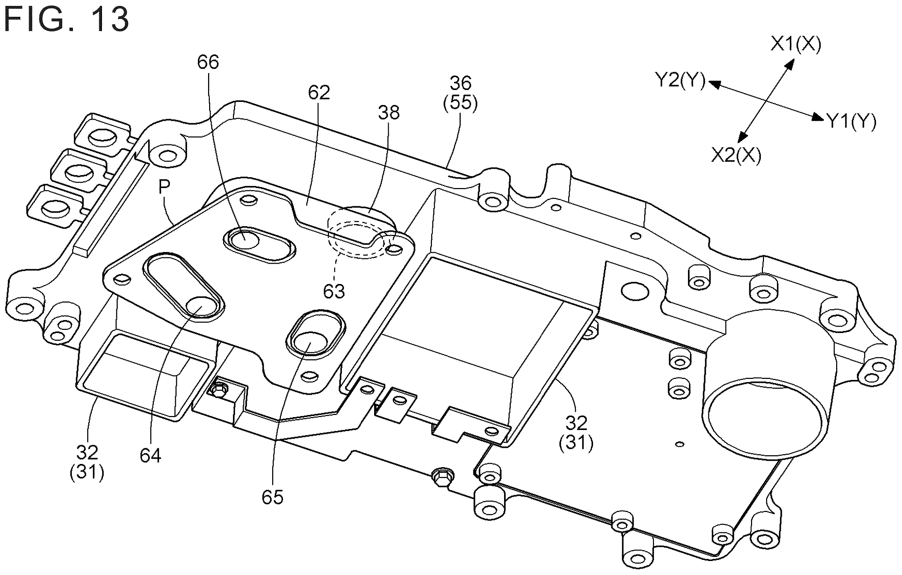

As shown in FIG. 13, in the present embodiment, the combination of the coolant inlet 63 and the coolant outlet 64 and the combination of the oil inlet 65 and the oil outlet 66 in the oil cooler 62 are each disposed diagonally on a plane projected along the lower plate 36a of the cooling plate 36. Specifically, on the plane projected along the lower plate 36a of the cooling plate 36, the coolant inlet 63 is disposed on the X1 direction side and the Y1 direction side, and the coolant outlet 64 is disposed on the X2 direction side and the Y2 direction side. Similarly, on the plane projected along the lower plate 36a, the oil inlet 65 is disposed on the X2 direction side and the Y1 direction side, and the oil outlet 66 is disposed on the X1 direction side and the Y2 direction side.

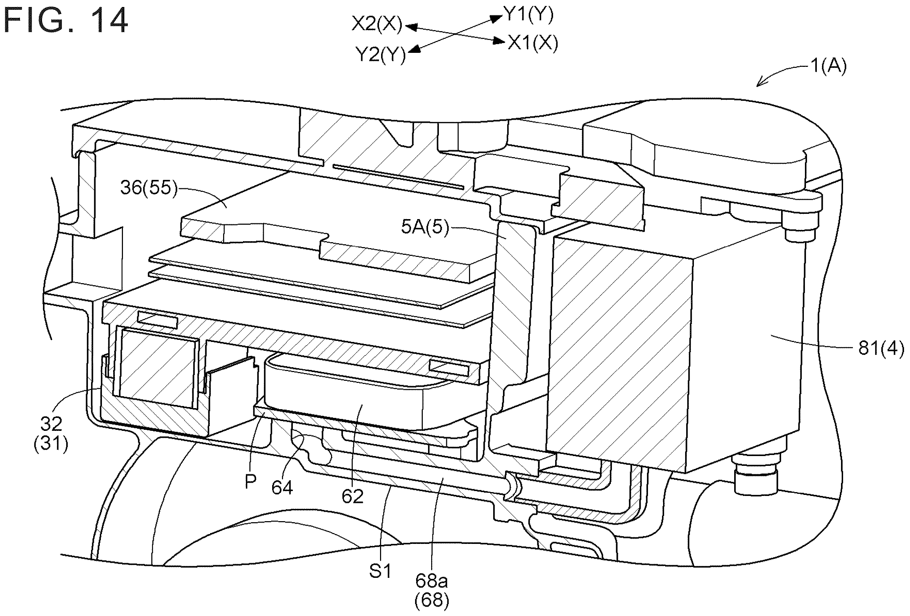

As shown in FIG. 14, the oil cooler 62 and the water-cooled condenser 81 are disposed at positions where they face each other across the wall (side surface 5A) of the unit case 5. As shown in FIG. 9, the water-cooled condenser 81 is attached to the side surface 5A of the unit case 5 at a position near the oil cooler 62. A channel portion 68 is provided between the coolant outlet 64 and the water-cooled condenser 81. In the example shown in FIG. 9, the channel portion 68 includes a first portion 68a formed along the wall surface of the partition wall S1, a second portion 68b bent from the lower surface 62B toward the upper surface 62A, and a third portion 68c extending in the same direction as that of the first portion 68a and continuous with the inside and outside of the unit case 5. That is, the third portion 68c is formed through the side surface 5A of the unit case 5 and is connected to the inside of the water-cooled condenser 81.

As shown in FIG. 14, the channel portion 68 may include only the first portion 68a along the partition wall S1 between the coolant outlet 64 of the oil cooler 62 and the water-cooled condenser 81 without the second portion 68b and the third portion 68c.

By disposing the oil cooler 62 and the water-cooled condenser 81 close to each other and providing the channel portion 68 between the coolant outlet 64 and the water-cooled condenser 81 in this way, the coolant pipe portion (channel portion 68) connected to the oil cooler 62 does not occupy a large area in the height direction of the oil cooler 62, and the integrated unit 1 can be made compact even when the oil cooler 62 is disposed between the vehicle drive unit 2 and the electronic circuit unit 3 (power supply module 100).

As shown in FIGS. 10, 15, and 16, the water pump 51 is fixed to the side surface 5A of the unit case 5 at a position where it overlaps at least part of the cooling plate 36 in side view. As shown in FIG. 10, the water pump 51 is disposed on the same side as that of the radiator 53 with respect to the integrated unit 1.

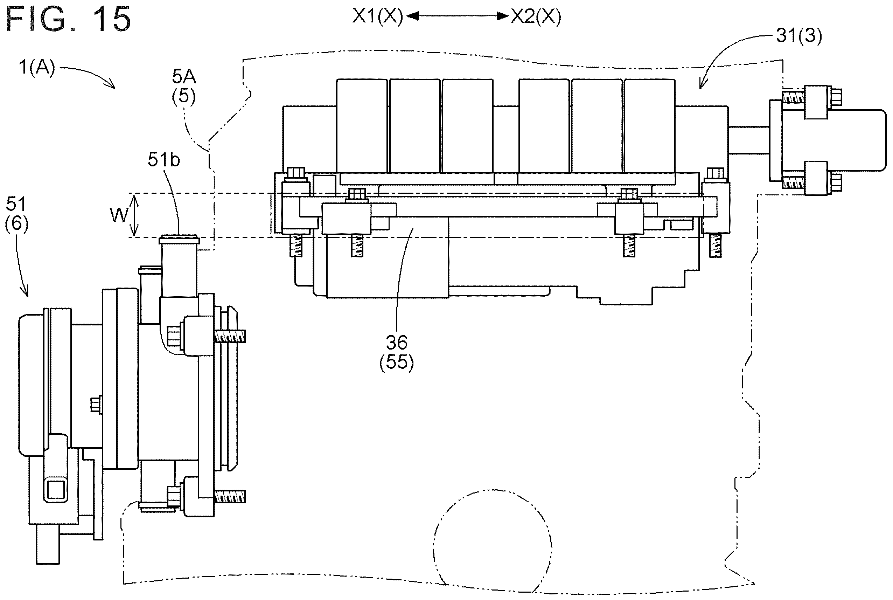

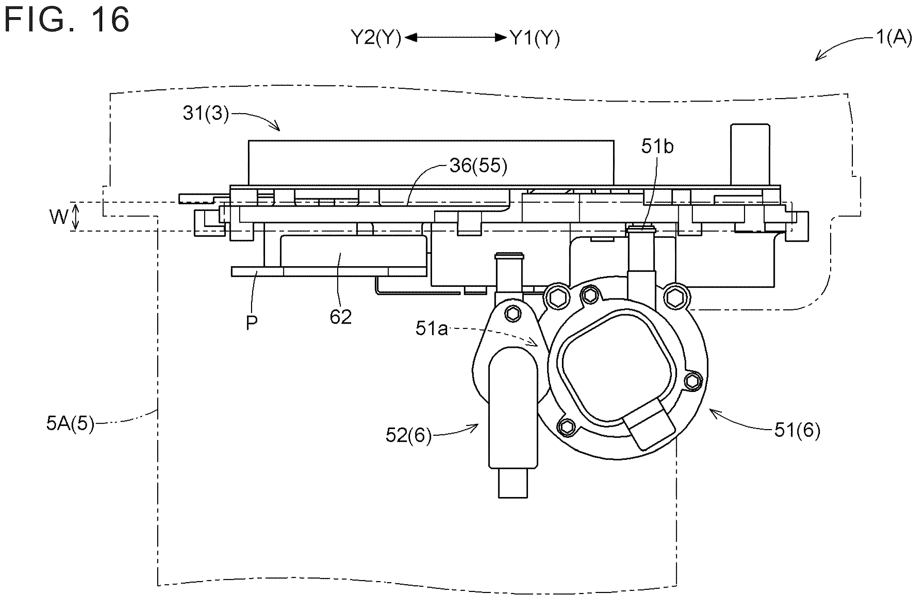

As shown in FIGS. 15 and 16, the water pump 51 includes a coolant suction port 51a and a coolant discharge port 51b, and is disposed so that the coolant discharge port 51b overlaps at least part of the cooling plate 36 in side view. Specifically, the coolant discharge port 51b of the water pump 51 is positioned within a width W of the cooling plate 36 in the vertical direction.

As shown in the schematic diagram of FIG. 10, the coolant discharge port 51b of the water pump 51 and the inlet 37 of the cooling plate 36 are connected by a connection channel 39. The connection channel 39 is provided below the cooling plate 36 and is formed along the bottom surface (lower plate 36a) of the cooling plate 36.

### [Fifth Embodiment]

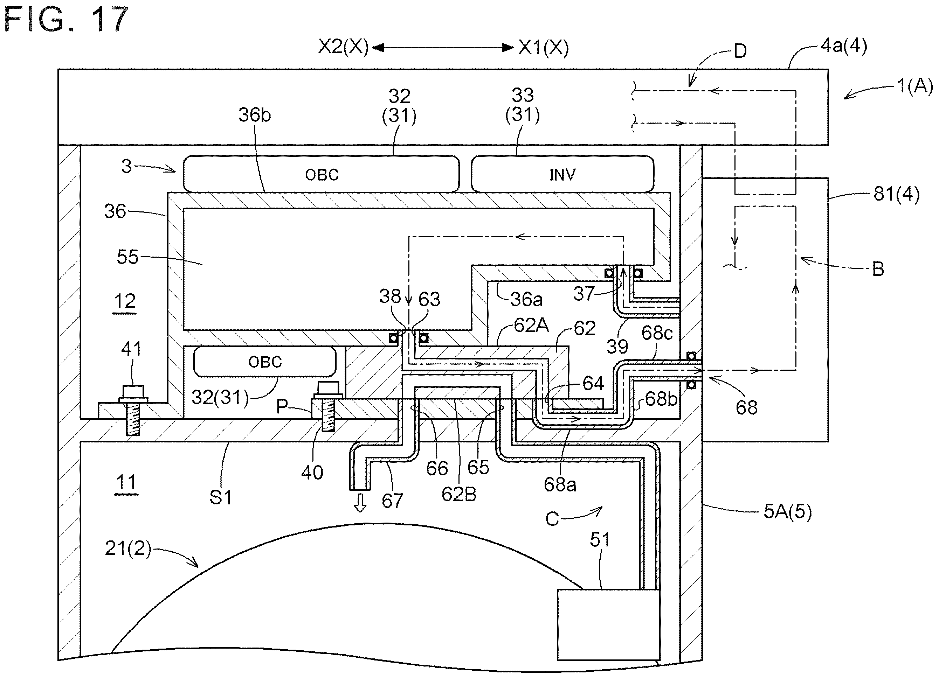

The fourth embodiment illustrates the example in which the refrigerant manifold 4a and the water-cooled condenser 81 are integrated and disposed outside the unit case 5. Alternatively, as shown in FIG. 17, the refrigerant manifold 4a and the water-cooled condenser 81 may be separated, and the refrigerant manifold 4a and the water-cooled condenser 81 may be attached individually to the integrated unit 1. Specifically, as shown in FIG. 17, the integrated unit 1 includes the refrigerant manifold 4a including the refrigerant channel D through which the refrigerant flows in a state in which the refrigerant manifold 4a is disposed above and separately from the water-cooled condenser 81, and the water-cooled condenser 81 is connected to the unit case 5 from the lateral side.

By connecting the water-cooled condenser 81 to the unit case 5 from the lateral side as in the present embodiment, the length of the pipe between the oil cooler 62 and the water-cooled condenser 81 can be reduced, and the integrated unit 1 can be made compact.

### [Other Embodiments]

(1) The above embodiments illustrate the example in which the water pump 51 and the valve 52 are integrated in the cooling channel B. However, the water pump 51 and the valve 52 may be provided separately, or the water pump 51 and the valve 52 may be housed in individual housings.
(2) The flow directions of the coolant and the refrigerant or the flow directions of the coolant and the oil for heat exchange may be the same directions or opposite directions.
(3) In the integrated unit 1 in the above embodiments, the vehicle drive unit 2 and the electronic circuit unit 3 are integrally housed in the unit case 5. However, the vehicle drive unit 2 and the electronic circuit unit 3 may be housed in different cases and the cases may be connected together.
(4) The above embodiments illustrate the example in which the oil cooler 62 includes the coolant inlet 63 provided on the upper surface 62A and the coolant outlet 64 provided on the lower surface 62B. Alternatively, the oil cooler 62 may include both the coolant inlet 63 and the coolant outlet 64 provided on the upper surface 62A.

### [Summary of Embodiments]

Hereinafter, the summary of the cooling system A described above will be provided.
(1) The characteristic configuration of the cooling system A is as follows. The cooling system A includes: the integrated unit 1 in which the electric vehicle drive unit 2 including at least the electric motor 21 configured to transmit the drive rotational force to the traveling system of the vehicle and the electronic circuit unit 3 including at least the electronic circuit 31 configured to drive the electric motor 21 are integrated; the cooling channel B through which the coolant circulates to the electronic circuit unit 3; and the oil channel C that includes the heat exchanger (oil cooler 62) configured to exchange heat with the coolant circulating through the cooling channel B and through which the oil circulates to the electric vehicle drive unit 2. The heat exchanger (oil cooler 62) is disposed inside the integrated unit 1 between the electric vehicle drive unit 2 and the electronic circuit unit 3.

In this configuration, the integrated unit 1 in which the electric vehicle drive unit 2 and the electronic circuit unit 3 are integrated is provided. Therefore, the integrated unit 1 can be downsized compared with a case where the electric vehicle drive unit 2 and the electronic circuit unit 3 are disposed separately. With the heat exchanger (oil cooler 62) that exchanges heat between the coolant and the oil, the waste heat of the electric vehicle drive unit 2 and the waste heat of the electronic circuit unit 3 can be recovered by the coolant.

In this configuration, the heat exchanger (oil cooler 62) is disposed inside the integrated unit 1 between the electric vehicle drive unit 2 and the electronic circuit unit 3. Thus, heat can be exchanged between the oil and the coolant inside the integrated unit 1, thereby improving the heat recovery rate. In the cooling channel B, the length of the pipe exposed from the heat exchanger (oil cooler 62) to the outside can be reduced.

In this way, the cooling system can suppress the dissipation of the waste heat of the electric vehicle drive unit from the cooling pipe, thereby achieving downsizing and efficient heat management.

(2) In the cooling system A according to (1), it is preferable that the cooling system A further include the cooling plate 36 to which the electronic circuit unit 3 is fixed and through which the coolant flows, and the heat exchanger (oil cooler 62) be disposed between the electric vehicle drive unit 2 and the cooling plate 36.

In this configuration, the electronic circuit unit 3 is fixed to the cooling plate 36. Thus, the heat generated by the electronic circuit unit 3 can be recovered by the coolant, and the heat recovery rate can be improved. In this configuration, the heat exchanger (oil cooler 62) is disposed inside the integrated unit 1 between the electric vehicle drive unit 2 and the cooling plate 36. Thus, heat can be exchanged between the oil and the coolant inside the integrated unit 1, thereby improving the heat recovery rate. In the cooling channel B, the length of the pipe exposed from the heat exchanger (oil cooler 62) to the outside can be reduced.

(3) In the cooling system A according to (2), it is preferable that the heat exchanger (oil cooler 62) be disposed below the cooling plate 36.

With this configuration, the coolant can smoothly flow from the cooling plate 36 to the heat exchanger (oil cooler 62), and the length of the pipe disposed between the cooling plate 36 and the heat exchanger (oil cooler 62) can be reduced.

(4) In the cooling system A according to any one of (1) to (3), it is preferable that the integrated unit 1 include the electric vehicle drive unit 2 and the electronic circuit unit 3 built into the housing (unit case 5).

Since the electric vehicle drive unit 2 and the electronic circuit unit 3 are integrally built into the housing (unit case 5), the integrated unit 1 can be downsized.

(5) In the cooling system A according to any one of (1) to (3), it is preferable that the electronic circuit 31 include the inverter 33 configured to control the current to be supplied from the battery 87 to the electric motor 21, and the voltage conversion circuit configured to control the voltage for charging the battery 87.

When the electronic circuit 31 included in the electronic circuit unit 3 includes not only the inverter 33 but also the voltage conversion circuit as in this configuration, further downsizing can be achieved.

(6) In the cooling system A according to any one of (1) to (5), it is preferable that the heat exchanger (oil cooler 62) include, individually on the lower surface 62B near the electric motor 21, the oil inlet 65 through which the oil flows in and the oil outlet 66 through which the oil flows out.

When the heat exchanger (oil cooler 62) is structured such that the oil flows in and out from the lower surface 62B as in this configuration, the integrated unit 1 can be made compact even when the heat exchanger (oil cooler 62) is disposed between the electric vehicle drive unit 2 and the electronic circuit unit 3.

(7) In the cooling system A according to any one of (2) to (5), it is preferable that the heat exchanger (oil cooler 62) include, on the upper surface 62A near the cooling plate 36, the coolant inlet 63 through which the coolant flows in and include, individually on the lower surface 62B near the electric motor 21, the coolant outlet 64 through which the coolant flows out, the oil inlet 65, and the oil outlet 66.

When the heat exchanger (oil cooler 62) is structured such that the oil flows in and out from the lower surface 62B and the heat exchanger (oil cooler 62) includes the coolant inlet 63 on the upper surface 62A and the coolant outlet 64 on the lower surface 62B as in this configuration, the integrated unit 1 can be made compact even when the heat exchanger (oil cooler 62) is disposed between the electric vehicle drive unit 2 and the electronic circuit unit 3.

(8) In the cooling system A according to (6) or (7), it is preferable that the oil flow out from the lower surface 62B toward the electric motor 21.

Since the oil flows out from the lower surface 62B of the heat exchanger (oil cooler 62) toward the electric motor 21 as in this configuration, the electric motor 21 can be cooled effectively.

(9) In the cooling system A according to (2) or (3), it is preferable that the heat exchanger (oil cooler 62) include the coolant outlet 64 that extends from the lower surface 62B near the electric motor 21 and through which the coolant flows out, and the cooling channel B extending from the coolant outlet 64 to the outside of the electronic circuit unit 3 be disposed below the upper surface 62A of the heat exchanger (oil cooler 62) near the cooling plate 36.

When the cooling channel B extending from the coolant outlet 64 of the heat exchanger (oil cooler 62) to the outside of the electronic circuit unit 3 is disposed below the upper surface 62A of the heat exchanger (oil cooler 62) near the cooling plate 36 as in this configuration, the cooling pipe does not occupy the heat exchanger (oil cooler 62) in the height direction, and the integrated unit 1 can be made compact even when the heat exchanger (oil cooler 62) is disposed between the electric vehicle drive unit 2 and the cooling plate 36.

(10) In the cooling system A according to (9), it is preferable that the coolant outlet 64 include the first portion 68a that is bent from the lower surface 62B toward the upper surface 62A, and the second portion 68b that is continuous with the first portion 68a and extends along the upper surface 62A, and the coolant be flowable out from the side of the heat exchanger (oil cooler 62) to the outside of the electronic circuit unit 3.

When the coolant outlet 64 of the heat exchanger (oil cooler 62) includes the first portion 68a that is bent from the lower surface 62B toward the upper surface 62A, and the second portion 68b that is continuous with the first portion 68a and extends along the upper surface 62A, and the coolant is flowable out from the side of the heat exchanger (oil cooler 62) to the outside of the electronic circuit unit 3 as in this configuration, the cooling pipe does not occupy the heat exchanger (oil cooler 62) in the height direction, and the integrated unit 1 can be made compact even when the heat exchanger (oil cooler 62) is disposed between the electric vehicle drive unit 2 and the cooling plate 36.

(11) In the cooling system A according to (2) or (3), it is preferable that the heat exchanger (oil cooler 62) be engaged with the cooling plate 36 via a projection and a recess.

With this configuration, heat can be exchanged between the oil and the cooling fluid inside the integrated unit 1, thereby improving the heat recovery rate. In the channel through which the cooling fluid flows, the length of the pipe between the heat exchanger (oil cooler 62) and the cooling plate 36 can be reduced. Thus, the cooling system A can suppress the dissipation of the waste heat of the electric vehicle drive unit 2 from the cooling pipe, thereby achieving downsizing and efficient heat management.

(12) In the cooling system A according to (11), it is preferable that the cooling plate 36 include the tubular outlet 38 that protrudes toward the heat exchanger (oil cooler 62), the heat exchanger (oil cooler 62) include, on the upper surface 62A near the cooling plate 36, the coolant inlet 63 through which the coolant flows in, and the outlet 38 be fitted into the coolant inlet 63.

In this configuration, the tubular outlet 38 of the cooling plate 36 and the coolant inlet 63 of the heat exchanger (oil cooler 62) are fitted together. Therefore, there is no need to install a pipe between the cooling plate 36 and the heat exchanger (oil cooler 62). Thus, the number of components can be reduced and the integrated unit 1 can be downsized.

(13) In the cooling system A according to (11), it is preferable that the heat exchanger (oil cooler 62) include the tubular coolant inlet 63 that protrudes from the upper surface 62Anear the cooling plate 36 and through which the coolant flows in, and the coolant inlet 63 be fitted into the outlet 38 of the cooling plate 36.

In this configuration, the outlet 38 of the cooling plate 36 and the tubular coolant inlet 63 of the heat exchanger (oil cooler 62) are fitted together. Therefore, there is no need to install a pipe between the cooling plate 36 and the heat exchanger (oil cooler 62). Thus, the number of components can be reduced and the integrated unit 1 can be downsized.

(14) In the cooling system A according to any one of (1) to (3), it is preferable that the integrated unit 1 include the partition wall S1 that separates the first space 11 in which the electric vehicle drive unit 2 is disposed and the second space 12 in which the electronic circuit unit 3 is disposed, and the heat exchanger (oil cooler 62) be disposed in the second space 12.

In this configuration, the integrated unit 1 includes the partition wall S1 that separates the first space 11 in which the electric vehicle drive unit 2 is disposed and the second space 12 in which the electronic circuit unit 3 is disposed. Therefore, the electric vehicle drive unit 2 and the electronic circuit unit 3 can easily be disposed at predetermined positions in the integrated unit 1. Since the heat exchanger (oil cooler 62) is disposed in the second space 12, the heat exchanger (oil cooler 62) and the cooling plate 36 can easily be engaged with each other.

(15) In the cooling system A according to (14), it is preferable that the heat exchanger (oil cooler 62) be fastened to the partition wall S1.

By fastening the heat exchanger (oil cooler 62) to the partition wall S1 as in this configuration, the integrated unit 1 can further be downsized. By fastening the heat exchanger (oil cooler 62) to the partition wall S1, the heat exchanger (oil cooler 62) can be attached from the top of the integrated unit 1.

(16) In the cooling system A according to (15), it is preferable that the integrated unit 1 include the support plate P that supports the heat exchanger (oil cooler 62), and the heat exchanger (oil cooler 62) be positioned relative to the partition wall S1 by the support plate P.

When the support plate P determines the position of the heat exchanger (oil cooler 62) relative to the partition wall S1 as in this configuration, the heat exchanger (oil cooler 62) can be installed with high accuracy relative to the partition wall S1. Therefore, the heat exchanger (oil cooler 62) can be installed at a position where the length of the pipe can be reduced. Thus, the integrated unit 1 can be downsized.

The following configurations are also possible from the above embodiments.

(17) The characteristic configuration of the cooling system A is as follows. The cooling system A includes: the integrated unit 1 in which the electric vehicle drive unit 2 including at least the electric motor 21 configured to transmit the drive rotational force to the traveling system of the vehicle and the electronic circuit unit 3 including at least the electronic circuit 31 configured to drive the electric motor 21 are integrated; the cooling channel B through which the coolant circulates to the electronic circuit unit 3; the oil channel C that includes the heat exchanger (oil cooler 62) configured to exchange heat with the coolant circulating through the cooling channel B and through which the oil circulates to the electric vehicle drive unit 2; and the refrigerant channel D that includes the water-cooled condenser 81 configured to exchange heat with the coolant circulating through the cooling channel B and through which the refrigerant for heating and cooling circulates. The cooling manifold (valve unit 6) in which part of the cooling channel B is formed inside the housing is attached integrally to the integrated unit 1.

In this configuration, the integrated unit 1 in which the electric vehicle drive unit 2 and the electronic circuit unit 3 are integrated is provided. Therefore, downsizing can be achieved compared with a case where the electric vehicle drive unit 2 and the electronic circuit unit 3 are disposed separately. Further, the heat exchanger (oil cooler 62) that exchanges heat between the coolant and the oil and the water-cooled condenser 81 that exchanges heat between the coolant and the refrigerant are provided. That is, the temperature of the coolant changes in the heat exchanger (oil cooler 62) by utilizing the waste heat of the electric vehicle drive unit 2 and in the water-cooled condenser 81 by utilizing the heat of the refrigerant.

In this configuration, the cooling manifold (valve unit 6) in which part of the cooling channel B is formed inside the housing is attached integrally to the integrated unit 1. That is, part of the cooling channel B through which the coolant circulates to exchange heat with both the oil and the refrigerant is integrated with the integrated unit 1. Thus, the length of the cooling pipe routed in the cooling channel B can be reduced, and the dissipation of the waste heat of the electric vehicle drive unit 2 from the cooling pipe can be suppressed.

In this way, the cooling system A can achieve downsizing and efficient heat management.

(18) In the cooling system A according to (17), it is preferable that the cooling manifold (valve unit 6) be disposed on the side surface of the electronic circuit unit 3.

By disposing the cooling manifold (valve unit 6) on the side surface of the electronic circuit unit 3 as in this configuration, the cooling pipe of the cooling channel B extending from the heat exchanger (oil cooler 62) provided to the electric vehicle drive unit 2 adjacent to the electronic circuit unit 3 can be designed so as not to be exposed to the outside. As a result, the dissipation of the waste heat of the electric vehicle drive unit 2 from the cooling pipe of the cooling channel B can be suppressed.

(19) In the cooling system A according to (17) or (18), it is preferable that the water-cooled condenser 81 be attached integrally to the cooling manifold (valve unit 6).

By integrally attaching the water-cooled condenser 81 to the cooling manifold (valve unit 6) as in this configuration, the cooling pipe can be designed so as not to be exposed to the outside when heat is exchanged between the coolant and the refrigerant. As a result, the dissipation of the waste heat of the electric vehicle drive unit 2 from the cooling pipe can be suppressed.

(20) In the cooling system A according to any one of (17) to (19), it is preferable that the heat exchanger (oil cooler 62) be attached integrally to the cooling manifold (valve unit 6).

By integrally attaching, to the cooling manifold (valve unit 6), the heat exchanger (oil cooler 62) provided to the electric vehicle drive unit 2 as in this configuration, the cooling pipe can be designed so as not to be exposed to the outside when heat is exchanged between the coolant and the oil. As a result, the dissipation of the waste heat of the electric vehicle drive unit 2 from the cooling pipe can be suppressed.

(21) In the cooling system A according to any one of (17) to (20), it is preferable that the heat exchanger (oil cooler 62) be disposed inside the integrated unit 1 between the electric vehicle drive unit 2 and the electronic circuit unit 3.

When the heat exchanger (oil cooler 62) is disposed inside the integrated unit 1 between the electric vehicle drive unit 2 and the electronic circuit unit 3 as in this configuration, heat can be exchanged between the oil and the coolant inside the integrated unit 1, thereby improving the heat recovery rate.

### INDUSTRIAL APPLICABILITY

The present invention is widely applicable to cooling systems for electric vehicles.

### Description of the Reference Numerals

1: integrated unit, 2: electric vehicle drive unit, 3: electronic circuit unit, 5: unit case (housing), 11: first space, 12: second space, 21: electric motor, 31: electronic circuit, 32: on-board charger (voltage conversion circuit), 33: inverter, 36: cooling plate, 37: inlet, 38: outlet, 53: radiator, 62: oil cooler (heat exchanger), 62A: upper surface, 62B: lower surface, 63: coolant inlet, 64: coolant outlet, 64A: first portion, 64B: second portion, 65: oil inlet, 66: oil outlet, A: cooling system, B: cooling channel, C: oil channel, D: refrigerant channel, S1: partition wall, P: support plate

## Claims

1. A cooling system comprising:
an integrated unit in which an electric vehicle drive unit including at least an electric motor configured to transmit a drive rotational force to a traveling system of a vehicle and an electronic circuit unit including at least an electronic circuit configured to drive the electric motor are integrated;
a cooling channel through which a coolant circulates to the electronic circuit unit; and
an oil channel that includes a heat exchanger configured to exchange heat with the coolant circulating through the cooling channel and through which oil circulates to the electric vehicle drive unit, wherein the heat exchanger is disposed inside the integrated unit between the electric vehicle drive unit and the electronic circuit unit.

2. The cooling system according to claim 1, further comprising a cooling plate to which the electronic circuit unit is fixed and through which the coolant flows, wherein the heat exchanger is disposed between the electric vehicle drive unit and the cooling plate.

3. The cooling system according to claim 2, wherein the heat exchanger is disposed below the cooling plate.

4. The cooling system according to any one of claims 1 to 3, wherein the integrated unit includes the electric vehicle drive unit and the electronic circuit unit built into a housing.

5. The cooling system according to any one of claims 1 to 3, wherein the electronic circuit includes an inverter configured to control a current to be supplied from a battery to the electric motor, and a voltage conversion circuit configured to control a voltage for charging the battery.

6. The cooling system according to any one of claims 1 to 3, wherein the heat exchanger includes, individually on a lower surface near the electric motor, an oil inlet through which the oil flows in and an oil outlet through which the oil flows out.

7. The cooling system according to claim 2 or 3, wherein
the heat exchanger includes, on an upper surface near the cooling plate, a coolant inlet through which the coolant flows in, and
the heat exchanger includes, individually on a lower surface near the electric motor, a coolant outlet through which the coolant flows out, an oil inlet through which the oil flows in, and an oil outlet through which the oil flows out.

8. The cooling system according to claim 6, wherein the oil flows out from the lower surface toward the electric motor.

9. The cooling system according to claim 2 or 3, wherein
the heat exchanger includes a coolant outlet that extends from a lower surface near the electric motor and through which the coolant flows out, and
the cooling channel extending from the coolant outlet to an outside of the electronic circuit unit is disposed below an upper surface of the heat exchanger near the cooling plate.

10. The cooling system according to claim 9, wherein the coolant outlet includes a first portion that is bent from the lower surface toward the upper surface, and a second portion that is continuous with the first portion and extends along the upper surface, and the coolant is flowable out from a side of the heat exchanger to the outside of the electronic circuit unit.

11. The cooling system according to claim 2 or 3, wherein the heat exchanger is engaged with the cooling plate via a projection and a recess.

12. The cooling system according to claim 11, wherein
the cooling plate includes a tubular outlet that protrudes toward the heat exchanger,
the heat exchanger includes, on an upper surface near the cooling plate, a coolant inlet through which the coolant flows in, and
the outlet is fitted into the coolant inlet.

13. The cooling system according to claim 11, wherein
the heat exchanger includes a tubular coolant inlet that protrudes from an upper surface near the cooling plate and through which the coolant flows in, and
the coolant inlet is fitted into an outlet of the cooling plate.

14. The cooling system according to any one of claims 1 to 3, wherein
the integrated unit includes a partition wall that separates a first space in which the electric vehicle drive unit is disposed and a second space in which the electronic circuit unit is disposed, and
the heat exchanger is disposed in the second space.

15. The cooling system according to claim 14, wherein the heat exchanger is fastened to the partition wall.

16. The cooling system according to claim 15, wherein
the integrated unit includes a support plate that supports the heat exchanger, and
the heat exchanger is positioned relative to the partition wall by the support plate.
